# EUROPEAN PATENT SPECIFICATION

(11) **EP 3 712 627 B1**
(45) Date of publication and mention of the grant of the patent: **24.05.2023**
(21) Application number: 20167946.1
(22) Date of filing: 29.03.2013
(51) Int. Cl.: G01R 31/00, H05K 13/08

(54) **ELECTRONIC COMPONENT MOUNTING MACHINE AND MEASUREMENT METHOD**
MASCHINE ZUR MONTAGE VON ELEKTRONISCHEN KOMPONENTEN UND MESSVERFAHREN
MACHINE DE MONTAGE DE COMPOSANTS ÉLECTRONIQUES ET PROCÉDÉ DE MESURE

(43) Date of publication of application: 23.09.2020
(62) Divisional of application: 13880038.8
(73) Proprietor: FUJI Corporation, Chiryu Aichi (JP)
(72) Inventor: OKADA, Takehito, Chiryu, Aichi (JP); HOSOI, Norio, Chiryu, Aichi (JP)
(74) Representative: Grünecker Patent- und Rechtsanwälte PartG mbB

(56) References cited:
- KR-B1- 101 230 596
- US-A- 5 443 534
- US-A1- 2012 287 437

## Description

### Technical Field

The present invention relates to an electronic component mounting machine which mounts an electronic component on a circuit board, and a measurement method for measuring electrical properties of the electronic component by a measuring device which is provided in the electronic component mounting machine.

### Background Art

Examples of an electronic component mounting machine include a machine which mounts an electronic component on a circuit board, and a machine which is provided with a measuring device. The measuring device includes a plurality of device side electrodes which correspond to a plurality of component side electrodes of the electronic component, and the plurality of device side electrodes are electrically connected to the plurality of component side electrodes. According to this, the electrical properties of the electronic component are measured. An electronic component mounting machine described in the following PTL 1 is one example of the electronic component mounting machine provided with a measuring device. Each of PTL 2, PTL 3 and PTL 4 disclose electronic component mounting machines according to the preamble of independent claim 1.
PTL 1: JP-A-2011-159964
PTL 2: US 5 443 534 A
PTL 3: KR 101 230 596 B1
PTL 4: US 2012/287437 A1

### Summary of Invention

### Technical Problem

According to the electronic component mounting machine provided with the measuring device, by measuring the electrical properties of the electronic component, it is possible to determine whether or not the electronic component is normal, or the like, and to ensure appropriate mounting work. However, since the distance between each of a plurality of component side electrodes is different from each type of electronic component, in order to measure the electrical properties of the multiple types of electronic components, it is necessary to equip the electronic component mounting machine with the plurality of measuring devices in which the distance between the device side electrodes is different from each other. In addition, the size of the electronic component is relatively small, and the component side electrodes of the electronic component are much smaller. For this reason, in order to bring the device side electrodes of the measuring device into contact with the component side electrodes of the electronic component, an extremely precise position control is necessary.

In this manner, the electronic component mounting machine provided with the measuring device has room for further improvement. For this reason, by realizing various types of improvement, practicality of the electronic component mounting machine provided with the measuring device is improved. In consideration of such a situation, an object of the present invention is to provide an electronic component mounting machine provided with a measuring device having high practicality, and a measurement method having high practicality for measuring electrical properties of an electronic component.

### Solution to Problem

The invention is defined in independent claim 1. Preferred embodiments are set out in the dependent claims.

### Brief Description of Drawings

[Fig. 1] Fig. 1 is a perspective view illustrating an electronic component mounting apparatus which is an example of the invention.
[Fig. 2] Fig. 2 is a plan view illustrating the electronic component mounting apparatus of Fig. 1 from above.
[Fig. 3] Fig. 3 is a perspective view illustrating a measuring device which is provided in the electronic component mounting apparatus of Fig. 1.
[Fig. 4] Fig. 4 is a sectional view along line AA illustrated in Fig. 3.
[Fig. 5] Fig. 5 is a block diagram illustrating a control device which is provided in the electronic component mounting apparatus of Fig. 1.
[Fig. 6] Fig. 6 is a side view of the measuring device for measuring electrical properties of the electronic component.
[Fig. 7] Fig. 7 is a side view of the measuring device for measuring the electrical properties of the electronic component.
[Fig. 8] Fig. 8 is a table illustrating a relationship between a device number, a target component, and a relative position.

### Description of Embodiments

Hereinafter, embodiments of the invention will be described in detail with reference to the drawings as an aspect for carrying out the invention.

### <Configuration of Board Work System>

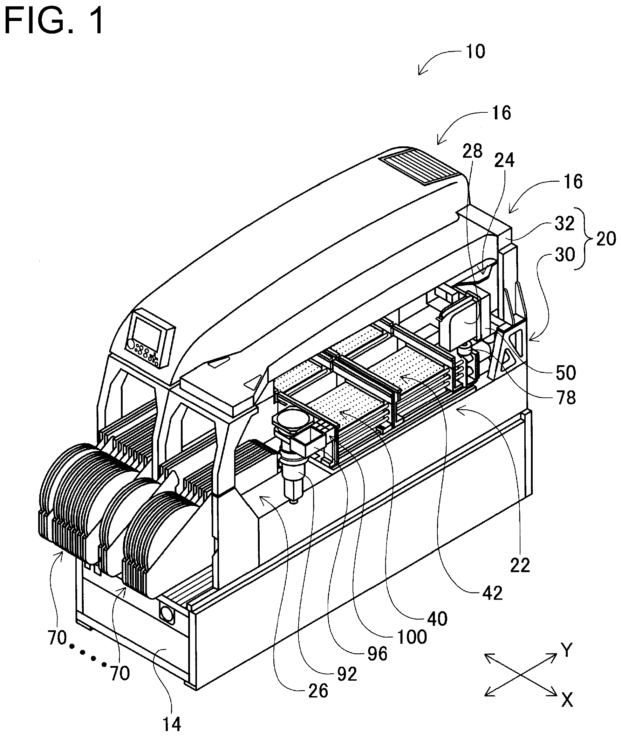

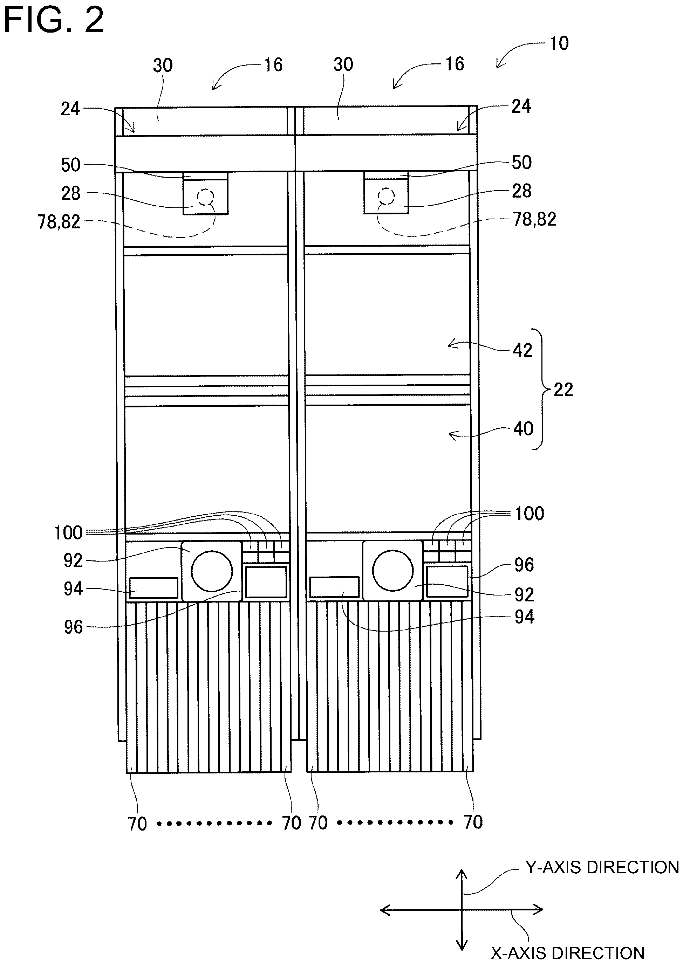

Figs. 1 and 2 illustrate an electronic component mounting apparatus 10. Fig. 1 is a perspective view of the electronic component mounting apparatus 10. Fig. 2 is a plan view illustrating the electronic component mounting apparatus 10 from above in a state where a cover or the like is removed. The electronic component mounting apparatus 10 is for mounting an electronic component on a circuit board. The electronic component mounting apparatus 10 includes one system base 14, and two mounting machines 16 which are installed being arranged on the system base 14. In addition, in the description below, a direction in which the mounting machines 16 are arranged is called an X-axis direction, and a horizontal direction which is perpendicular to the X-axis direction is called Y-axis direction.

Each of the mounting machines 16 primarily includes a mounting machine main body 20, a transporting device 22, a mounting head moving device (hereinafter, there is a case of being referred to as a "moving device") 24, a supply device 26, and a mounting head 28. The mounting machine main body 20 is configured of a frame section 30, and a beam section 32 which is constructed in the frame section 30.

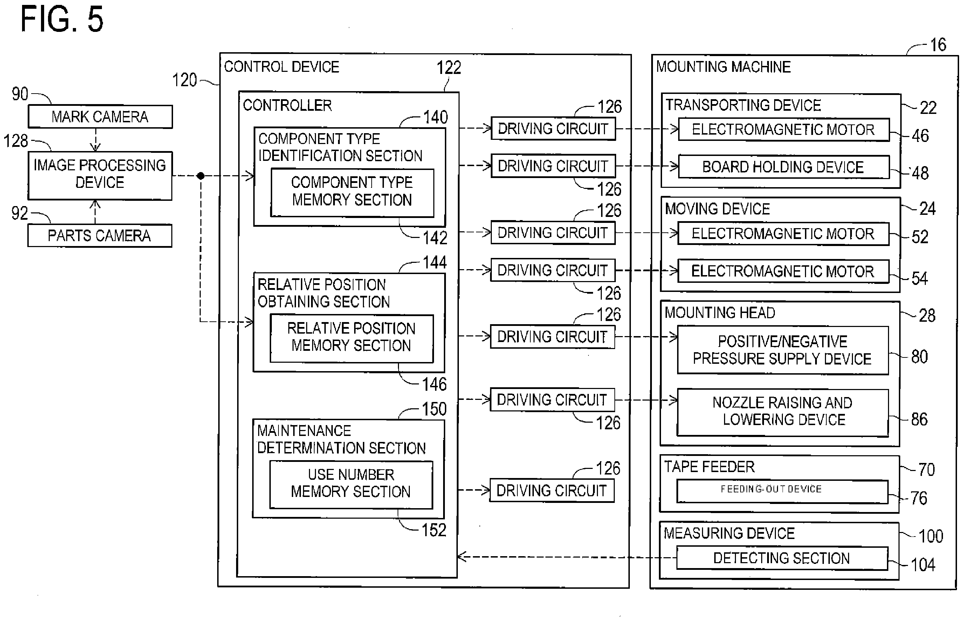

The transporting device 22 is provided with two conveyor devices 40 and 42. The conveyor devices 40 and 42 are parallel to each other, and are installed on the frame section 30 to extend in the X-axis direction. Each of the two conveyor devices 40 and 42 transports the circuit board which is supported by each of the conveyor devices 40 and 42 by an electromagnetic motor (refer to Fig 5) 46 in the X-axis direction. In addition, the circuit board is held being clamped by a board holding device (refer to Fig. 5) 48 at a predetermined position.

The moving device 24 is an XY robot type moving device. The moving device 24 is provided with an electromagnetic motor (refer to Fig. 5) 52 which slides a slider 50 in the X-axis direction, and an electromagnetic motor (refer to Fig. 5) 54 which slides the slider 50 in the Y-axis direction. The mounting head 28 is attached to the slider 50, and the mounting head 28 moves to an arbitrary position on the frame section 30 by operations of the two electromagnetic motors 52 and 54.

The supply device 26 is a feeder type supply device, and is installed in an end section on a front side of the frame section 30. The supply device 26 has a tape feeder 70. The tape feeder 70 houses a wound taped component. The taped component is a component in which the electronic component is contained in a tape. In addition, the tape feeder 70 feeds out the taped component by a feeding-out device (refer to Fig. 5) 76. Accordingly, the feeder type supply device 26 supplies the electronic component at a supply position by feeding out the taped component. In addition, the tape feeder 70 is attachable to and detachable from the frame section 30, and allows for the replacement or the like of the electronic component.

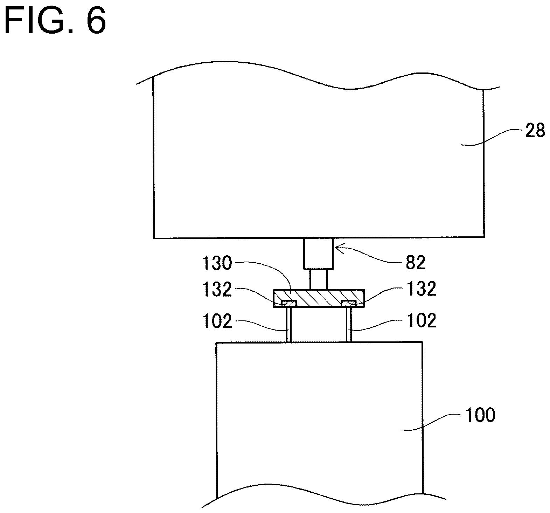

The mounting head 28 mounts the electronic component on the circuit board. The mounting head 28 includes a suction nozzle 78 which is provided on a lower end surface. The suction nozzle 78 leads to a positive/negative pressure supply device (refer to Fig. 5) 80 via a negative pressure air passage and a positive pressure air passage. The suction nozzle 78 sucks and holds the electronic component by negative pressure, and the held electronic component is disengaged by positive pressure. In addition, the suction nozzle 78 is formed of a conductive material, and is attachable to and detachable from the mounting head 28. In addition, it is possible to replace the suction nozzle (hereinafter, there is a case of being referred to as a "conductive nozzle") 78 which is formed of a conductive material with a suction nozzle (hereinafter, there is a case of being referred to as an "insulating nozzle") (refer to Fig. 6) 82 which is formed of an insulating material. Furthermore, the mounting head 28 includes a nozzle raising and lowering device (refer to Fig. 5) 86 which raises and lowers the conductive nozzle 78 or the insulating nozzle 82. The mounting head 28 changes the position of the held electronic component in a vertical direction by the nozzle raising and lowering device 86.

In addition, the mounting machine 16 is provided with a mark camera (refer to Fig. 5) 90 and a parts camera (refer to Figs. 1 and 2) 92. The mark camera 90 is fixed to a lower surface of the slider 50 in a state of facing downward. Accordingly, as the slider 50 is moved by the moving device 24, it is possible to image an arbitrary position on the frame section 30. Meanwhile, the parts camera 92 is provided in the frame section 30 between the transporting device 22 and the supply device 26 in a state of facing upward, and images the electronic component held by the suction nozzles 78 and 82 of the mounting head 28.

On a side of the parts camera 92, that is, in the frame section 30 between the transporting device 22 and the supply device 26, a work tool station 94 is provided. The work tool station 94 accommodates the insulating nozzle 82, and automatically replaces the conductive nozzle 78 mounted on the mounting head 28 with the insulating nozzle 82 accommodated in the work tool station 94. In addition, on a side opposite to the work tool station 94 of the parts camera 92, a disposal box 96 is provided. The disposal box 96 is for disposing of the electronic component which is not appropriate for mounting on the circuit board.

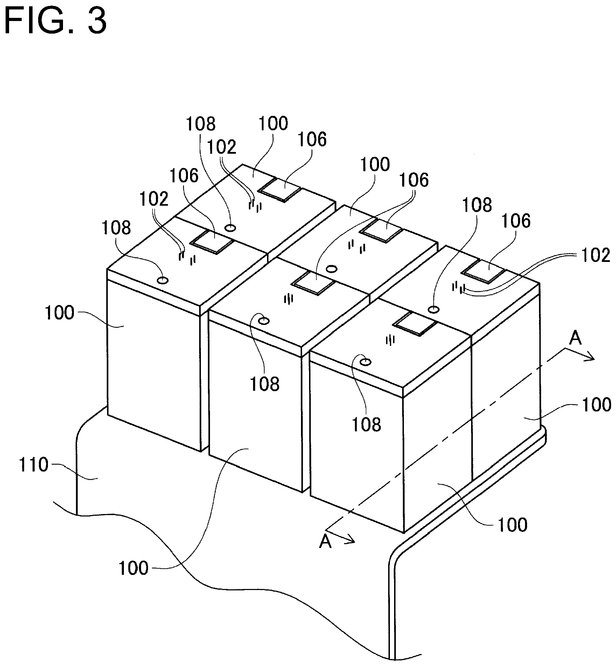

On a side of the disposal box 96, six measuring devices 100 are installed. As illustrated in Fig. 3, each measuring device 100 includes a plurality of probes 102. The plurality of probes 102 are provided on an upper surface of the measuring device 100, and protrude upward. In addition, a plurality of electrodes of the electronic component are electrically connected to the plurality of probes 102, and a voltage is applied to the probe 102. According to this, the electrical properties of the electronic component are measured in a detecting section (refer to Fig. 5) 104 of the measuring device 100. Specifically, if the electronic component is a capacitor or the like, an electrostatic capacity is measured, and if the electronic component is a resistance element, a diode or the like a resistance value is measured. In addition, the plurality of probes 102 of each of the measuring devices 100 are provided corresponding to the plurality of electrodes of the electronic component. For example, two probes 102 are provided in the electronic component having two electrodes, and a distance between the two probes 102 is a distance between the two electrodes of the electronic component. In addition, three or more probes 102 are provided in the electronic component having three or more electrodes, such as a lead component, and the three or more probes 102 are installed corresponding to the three or more electrodes. For this reason, the dispositions of the plurality of probes 102 each measuring device 100 has are different from each other.

In addition, an identification plate 106 on which an identification code, such as 2D code (for example, a bar code, and a "QR code" (registered trademark)) is indicated, is attached to the upper surfaces of each measuring device 100. The identification code provided on the identification plate 106 is different for every measuring device 100, and it is possible to distinguish the measuring device 100 by the information read from the identification code. Furthermore, a fiducial mark 108 is provided on the upper surfaces of each measuring device 100. The fiducial mark 108 will be described in detail later. The fiducial mark 108 is used when the electrode of the electronic component is electrically connected to the probe 102.

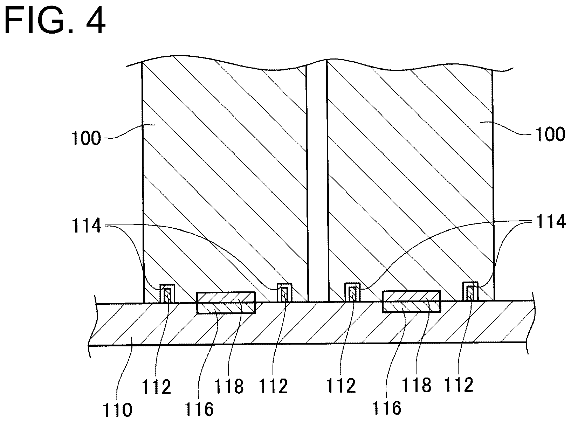

In addition, the measuring device 100 is detachably mounted to and detachable from a mounting table 110 provided on the frame section 30 between the transporting device 22 and the supply device 26. Specifically, as illustrated in Fig. 4, a plurality of convex sections 112 are formed on the upper surface of the mounting table 110. Meanwhile, a concave section 114 having a shape which corresponding to the convex section 112 is formed on a lower surface of the measuring device 100. In addition, as the concave section 114 of the measuring device 100 is fitted to the convex section 112 of the mounting table 110, the measuring device 100 is mounted at a predetermined position of the mounting table 110.

Furthermore, a magnet 116 is fixed to an upper surface of the mounting table 110, and a magnet 118 which is a magnet opposite to the magnet 116 is fixed to a lower surface of the measuring device 100. In addition, as the concave section 114 of the measuring device 100 is fitted to the convex section 112 of the mounting table 110, the magnets 116 and 118 face each other. Accordingly, the measuring device 100 is mounted on the mounting table 110 by the magnet.

In this manner, only by fitting the concave section 114 to the convex section 112, the measuring device 100 is mounted on the mounting table 110. In addition, by holding up the measuring device 100 upward against a magnetic force, it is possible to detach the measuring device 100 from the mounting table 110. In other words, without using a tool or the like, the measuring device 100 is attachable to and detachable from the mounting table 110 in a single operation.

Meanwhile, six measuring devices 100 are mounted on the mounting table 110, but another measuring device 100 in addition to the six measuring devices 100 is prepared, and it is possible to detach the measuring device 100 which is mounted on the mounting table 110 from the mounting table 110, and to mount the prepared measuring device 100 to the mounting table 110. In addition, the dispositions of the plurality of probes 102 the prepared measuring device 100 has are different from the dispositions of the plurality of probes 102 the measuring device 100 mounted on the mounting table 110 has.

Furthermore, as illustrated in Fig. 5, the mounting machine 16 is provided with a control device 120. The control device 120 is provided with a controller 122 and a plurality of driving circuits 126. The plurality of driving circuits 126 are connected to the above-described electromagnetic motors 46, 52, and 54, the board holding device 48, the feeding-out device 76, the positive/negative pressure supply device 80, and the nozzle raising and lowering device 86. The controller 122 is provided with a CPU, a ROM, a RAM and the like, primarily composed of a computer, and connected to the plurality of driving circuits 126. Accordingly, operations of the transporting device 22, the moving device 24 and the like, are controlled by the controller 122.

The controller 122 is connected to an image processing device 128 which processes image data obtained by the mark camera 90 and the parts camera 92. Accordingly, the controller 122 obtains various types of information from the image data. In addition, the controller 122 is also connected to the detecting section 104 of each of the measuring devices 100. Accordingly, the controller 122 obtains the electrostatic capacity and the electrical properties, such as a resistance value, of the electronic component, which are measured by the measuring device 100.

### <Mounting Work by Mounting Machine>

In the mounting machine 16, by the above-described configuration, it is possible to perform mounting work by the mounting head 28 on the circuit board held by the transporting device 22. Specifically, by a command of the controller 122, the circuit board is transported up to a work position, and at this position, the circuit board is held being clamped by the board holding device 48. In addition, by the command of the controller 122, the tape feeder 70 feeds out the taped component, and supplies the electronic component at the supply position. In addition, by the command of the controller 122, the mounting head 28 moves above the supply position of the electronic component, and sucks and holds the electronic component by the conductive nozzle 78. Next, by the command of the controller 122, the mounting head 28 moves above the circuit board, and mounts the held electronic components on the circuit board.

### <Measurement of Electrical Properties of Electronic Component>

As described above, in the mounting machine 16, the mounting head 28 sucks and holds the electronic component supplied by the tape feeder 70, and the electronic component is mounted on the circuit board. In the mounting machine 16 configured in this manner, insufficient supply of the electronic component is to be avoided, and when the number of electronic components which are housed in the tape feeder 70 is smaller than a predetermined number, a screen image for urging replacement or the like of the tape feeder 70 is displayed in a display device (not illustrated). Then, an operator performs replacement or the like of the tape feeder 70 following the displayed screen image. Accordingly, it is possible to appropriately conduct the replenishment, replacement or the like of the electronic component.

However, there is a case where the operator mistakenly replaces the tape feeder 70 in which an electronic component which is different from the electronic component to be mounted is housed. In addition, there is a case where a component manufacturer loads and delivers an electronic component which is different from a genuine electronic component to a component package. In consideration of these situations, in the mounting machine 16, when the tape feeder 70 is replaced, the electrical properties of the electronic component are measured, and it is determined whether or not the tape feeder is replaced with an appropriate tape feeder 70, that is, whether or not an appropriate electronic component is replenished.

Specifically, when replacing the tape feeder 70, the conductive nozzle 78 mounted on the mounting head 28 is exchanged to the insulating nozzle 82. In other words, by the command of the controller 122, the mounting head 28 which has the conductive nozzle 78 mounted thereon moves above the work tool station 94, and in the work tool station 94, the conductive nozzle 78 mounted on the mounting head 28 is replaced with the insulating nozzle 82 accommodated in the work tool station 94.

In addition, by the command of the controller 122, the mounting head 28 which has the insulating nozzle 82 mounted thereon moves above the supply position of the electronic component, and sucks and holds the electronic component by the insulating nozzle 82. Next, by the command of the controller 122, the mounting head 28 moves above the parts camera 92, and images the electronic component which is sucked and held by the insulating nozzle 82 by the parts camera 92. This is for making the controller 122 recognize the position of the electrode of the electronic component with respect to the center of the insulating nozzle 82. By the command from the controller 122 based on the recognition result, the mounting head 28 moves above the measuring device 100. In addition, the electrical properties of the held electronic component are measured by the measuring device 100.

Specifically, above the measuring device 100, the mounting head 28 lowers the held electronic component by the nozzle raising and lowering device 86. Accordingly, as illustrated in Fig. 6, a plurality of electrodes 132 of an electronic component 130 which is held by the insulating nozzle 82 are pressed to the plurality of probes 102 of the measuring device 100. In other words, the electrode 132 of the electronic component 130 and the probe 102 of the measuring device 100 are electrically connected to each other. In addition, as the electrode 132 is pressed to the probe 102, even when the front surface of the electrode 132 is covered with an oxide film or the like, it is possible to appropriately measure the electrical properties.

When the electrode 132 of the electronic component 130 and the probe 102 of the measuring device 100 are electrically connected to each other, a voltage is applied to the probe 102, and the electrical properties of the electronic component 130 are measured by the detecting section 104 of the measuring device 100. In addition, since the electronic component 130 is held by the insulating nozzle 82, a current does not leak via the insulating nozzle 82, and the electrical properties of the electronic component 130 are appropriately measured.

In addition, the measured electrical properties of the electronic component 130, and the electrical properties of the electronic component which is a target to be replenished are compared to each other. The electrical properties of the electronic component are different in each type of electronic component, and when an incorrect electronic component is replenished, the measured electrical properties of the electronic component 130 and the electrical properties of the electronic component which is a target to be replenished are different from each other. For this reason, when the measured electrical properties of the electronic component 130 and the electrical properties of the electronic component which is a target to be replaced are different from each other, it is determined that an incorrect electronic component is replenished, and an error screen image is displayed in the display device or the like.

Meanwhile, when the measured electrical properties of the electronic component 130 and the electrical properties of the electronic component which is a target to be replaced match each other, it is determined that an appropriate electronic component is replenished, and the mounting work which uses the replenished electronic component is performed.

In addition, the electronic component 130 of which the electrical properties are measured is electrically charged. This is because a voltage is applied to the electronic component 130 held by the insulating nozzle 82. It is not preferable to mount the charged electronic component 130 on the circuit board since the electricity charged to the electronic component 130 flows into the circuit board. For this reason, the electronic component of which the electrical properties are measured is disposed of to the disposal box 96.

In addition, when it is determined that an appropriate electronic component is replenished, after disposal of the electronic component of which the electrical properties are measured to the disposal box 96, the mounting work is restarted. At this time, the insulating nozzle 82 which is mounted on the mounting head 28 is exchanged with the conductive nozzle 78 in the work tool station.

In this manner, by measuring the electrical properties of the electronic component which is newly replenished, it is possible to determine whether or not an appropriate electronic component is replenished, and to ensure appropriate mounting work.

### <Identification of Electronic Component Which is Measurable by Measuring Device>

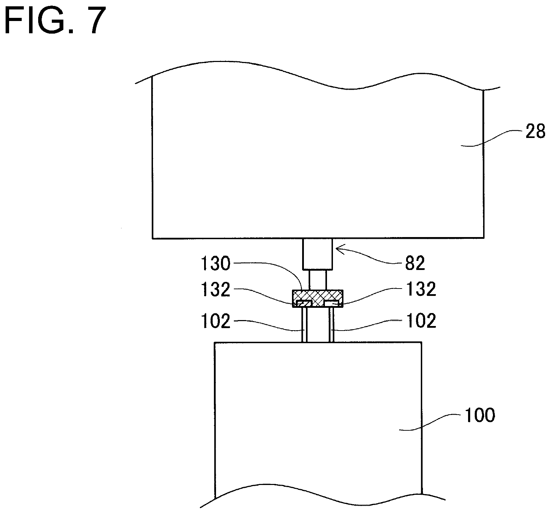

In addition, as described above, the disposition of the plurality of probes 102 of each measuring device 100 is different each other, and the types of the measurable electronic component 130 are also different for each measuring device 100. This is because the disposition of the plurality of electrodes 132 of the electronic component 130 is different for every type of electronic component 130, as compared to each other in Figs. 6 and 7. For this reason, in the mounting machine 16, the type of measurable electronic component 130 which is measurable by each measuring device 100 is automatically identified.

Specifically, as described above, the identification plate 106 for identifying each measuring device 100 is attached to each measuring device 100. The identification plate 106 is imaged by the mark camera 90, and the imaging data is processed by the image processing device 128. Accordingly, the controller 122 obtains the device numbers of each of the measuring devices 100. The device number is a simple symbol for distinguishing each measuring device 100, and for example, may be a simple number, such as "01" or "02", and may be a combination of a number and an alphabet, such as "A1" or "B2".

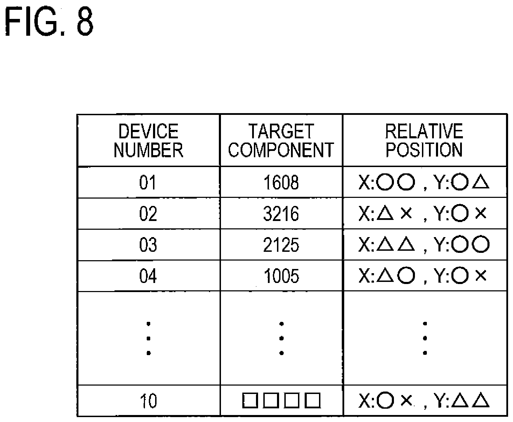

In addition, in the controller 122, the device number and the type of the electronic component 130 which is measurable by the measuring device 100 of the device number, are associated with each other and stored. Specifically, a map data which corresponds to Fig. 8 is stored. In the drawing, the numbers, such as "01" or "02" are employed as the device number, and a target component which is the electronic component 130 that is measurable by the measuring device 100 of the device number is stored in every device number. The numbers described in a column of "target component" are numbers which indicate a dimension of the electronic component 130, and for example, "1608" indicates a generally rectangular electronic component having a long side of 1.6 mm, and a short side of 0.8 mm. In other words, the measuring device 100 of the device number "01" can measure the electrical properties of the generally rectangular electronic component having a long side of 1.6 mm, and a short side of 0.8 mm.

By the controller 122, the device number obtained by imaging the identification plate 106, and the type of the electronic component 130 which is measurable by each measuring device 100 based on the map data which corresponds to Fig. 8, are obtained. In this manner, by the mounting machine 16, the type of the electronic component 130 which is measurable by each measuring device 100 is automatically identified. Accordingly, it is possible to efficiently perform measurement of the electrical properties of electronic component.

In addition, as a functional section for automatically identifying the type of the electronic component 130 which is measurable by each measuring device 100, as illustrated in Fig. 5, the controller 122 has a component type identification section 140. Furthermore, the component type identification section 140 has a component type memory section 142 as a functional section which stores the map data that corresponds to Fig. 8.

### <Relative Position of Probe and Fiducial Mark>

In addition, the size of the electronic component 130 is extremely small, and the size of the electrode 132 of the electronic component 130 is much smaller. For this reason, when the probe 102 of the measuring device 100 and the electrode 132 of the electronic component 130 come into contact with each other, it is necessary to perform precise position control. For this reason, the fiducial mark 108 is provided on the upper surfaces of each measuring device 100, and when the probe 102 and the electrode 132 are brought into contact with each other, the position control is performed by using the fiducial mark 108 as a reference. Since the distance between the fiducial mark 108 and the probe 102 is relatively short, it is possible to appropriately perform position control.

However, by using the fiducial mark 108 as a reference, in order to bring the probe 102 into contact with the electrode 132, it is needless to say that a relative positional relationship between the probe 102 and the fiducial mark 108 is necessary. The relative positional relationship between the probe 102 and the fiducial mark 108 is also automatically obtained by the mounting machine 16.

Specifically, in the controller 122, the device number obtained by imaging the identification plate 106, and the relative positional relationship between the probe 102 and the fiducial mark 108 in the measuring device 100 of the device number, are associated with each other and stored. Specifically, a map data which corresponds to Fig. 8 is stored. In the drawing, the relative positional relationship between the probe 102 and the fiducial mark 108 are stored in every device number. The numbers described in the column "relative position" are numbers which indicate distances between the probe 102 and the fiducial mark 108 in the X-axis direction and in the Y-axis direction, which are at a position where the insulating nozzle 82 is stopped for measurement. For example, "X:○○, Y:○Δ" indicates that the distance between the probe 102 and the fiducial mark 108 in the X-axis direction is ○○ mm, and the distance in the X-axis direction is ○Δ mm.

By the controller 122, the device number obtained by imaging the identification plate 106, and the distance between the probe 102 and the fiducial mark 108 in the X-axis direction and in the Y-axis direction, based on the map data which corresponds to Fig. 8, are obtained. In this manner, by the mounting machine 16, the relative positional relationship between the probe 102 and the fiducial mark 108 in each measuring device 100 is automatically obtained. Accordingly, it is possible to perform appropriate position control, and to appropriately perform measurement of the electrical properties of the electronic component.

In addition, as a functional section for automatically obtaining the relative positional relationship between the probe 102 and the fiducial mark 108 in each measuring device 100, the controller 122 includes a relative position obtaining section 144 as illustrated in Fig. 5. Furthermore, as a functional section for storing the map data which corresponds to Fig. 8, the relative position obtaining section 144 includes a relative position memory section 146.

### <Replacement of Measuring Device>

In addition, when the type of circuit board to be manufactured is replaced, the electronic component to be mounted is also changed. At this time, there is a case where the electrical properties of the electronic component which is newly replaced cannot be measured by each measuring device 100 mounted on the mounting table 110. In other words, there is a case where the type of electronic component which is measurable by each measuring device 100 mounted on the mounting table 110, and the type of electronic component which is newly replaced, are different from each other. In this case, the user can mount the measuring device 100 which can measure the electrical properties of the electronic component which is newly replaced, on the mounting table 110.

Specifically, as described above, the measuring device 100 is attachable to and detachable from the mounting table 110 in a single operation. Furthermore, in addition to the six measuring devices 100 mounted on the mounting table 110, another measuring device 100 is prepared, and the disposition of the plurality of probes 102 the prepared measuring device 100 has, and the disposition of the plurality of probes 102 the measuring device 100 mounted on the mounting table 110 has, are different from each other. In other words, the measuring device 100 which can measure the electrical properties of the electronic component which is newly replaced is prepared separately from the six measuring devices 100 mounted on the mounting table 110.

For this reason, the user detaches the measuring device 100 which can measure the electrical properties of the electronic component that is not necessary in the manufacturing of a new circuit board, from the mounting table 110, and can attach the measuring device 100 which can measure the electrical properties of the electronic component that is newly replaced, instead of the detached measuring device 100. In this manner, in accordance with the type or the like of electronic component, by replacing the measuring device 100, it is possible to handle the plural types of electronic components.

### <Maintenance of Measuring Device>

In addition, the number of uses of the measuring device 100 is managed by the mounting machine 16, and a command of maintenance work in accordance with the number of uses is notified to the operator. Specifically, in the controller 122, the number of uses and maintenance history of a measuring device 100 are stored in each measuring device 100. In addition, when each measuring device 100 is used, the number of uses of each measuring device 100 is updated. In addition, when the number of uses is updated, the number of uses of the measuring device 100 in accordance with the device number obtained by imaging the identification plate 106 is updated.

In addition, in the controller 122, the limited number of uses set in advance is stored in each measuring device 100. The limited number of uses is the number which is set by considering wear or the like of the probe 102 of each measuring device 100. In addition, in the controller 122, the number of uses and the limited number of uses of the measuring device 100 are compared to each other in each measuring device 100, and when the number of uses reaches the limited number of uses, the command of the maintenance work is notified to the operator. Accordingly, the operator detaches the measuring device 100 from the mounting table 110 following the notification, and performs the maintenance work, such as replacement or cleaning of the probe 102. According to this, it is possible to maintain the measuring accuracy of the measuring device 100.

In addition, as a functional section for comparing the number of uses and the limited number of uses in each measuring device 100, and for determining whether or not the maintenance work is to be performed, as illustrated in Fig. 5, the controller 122 includes a maintenance determination section 150. Furthermore, as a functional section for storing the number of uses of each measuring device 100, the maintenance determination section 150 includes a use number memory section 152.

In other words, in the above-described embodiment, the mounting machine 16 is an example of the electronic component mounting machine. The mounting head 28 is an example of a mounting head. The conductive nozzle 78 is an example of a conductive nozzle. The insulating nozzle 82 is an example of an insulating nozzle. The mark camera 90 is an example of an imaging device. The disposal box 96 is an example of a disposal device. The measuring device 100 is an example of a measuring device. The probe 102 is an example of a device side electrode and a probe. The identification plate 106 is an example of an identification code. The fiducial mark 108 is an example of a reference mark. The mounting table 110 is an example of a mounting section. The electronic component 130 is an example of an electronic component. The electrode 132 is an example of a component side electrode. The component type identification section 140 is an example of an identification device. The component type memory section 142 is an example of a component type memory section. The relative position obtaining section 144 is an example of a relative position obtaining section. The relative position memory section 146 is an example of a relative position memory section.

In addition, a step of holding the electronic component 130 by the insulating nozzle 82 is an example of an electronic component holding step. A step of measuring the electrical properties of the electronic component 130 by the measuring device 100 is an example of a measuring step. A step of disposing of the electronic component of which the electrical properties are measured to the disposal box 96 is an example of a disposal step.

In addition, the invention is not limited to the above-described embodiment, and can be carried out by various modified and improved aspects based on the knowledge of the operator. Specifically, for example, in the above-described embodiment, in order to determine whether or not the electronic component is appropriately replenished, the electrical properties of the electronic component are measured. However, the electrical properties of the electronic component may be measured in order to determine whether or not the electronic component is normal.

In addition, in the above-described embodiment, the convex section 112 and the concave section 114 are fitted to each other, and the measuring device 100 is mounted on the mounting table 110 by the magnetic force. However, mounting the measuring device 100 on the mounting table 110 can be achieved by fitting the convex section 112 and the concave section 114 without the magnetic force. In addition, by a locking mechanism or the like which is used in a spring, it is possible to mount the measuring device 100 on the mounting table 110. In addition, it is possible to mount the measuring device 100 on the mounting table 110 by a bolt or the like. In other words, by using a tool or the like, it is possible to mount the measuring device 100 on the mounting table 110.

In addition, in the above-described embodiment, the device number of each measuring device 100 is obtained by imaging the identification plate 106, and the type of the electronic component 130 which is measurable by the measuring device 100 and the relative position of the probe 102 and the fiducial mark 108 in each measuring device 100, are obtained based on the map data or the like stored in the controller 122. However, it is possible to obtain the type of the electronic component 130 which is measurable by the measuring device 100 and the relative position of the probe 102 and the fiducial mark 108 in each measuring device 100 by imaging the identification plate 106. In other words, by employing a code which includes the type of the electronic component 130 which is measurable by the measuring device 100 and the relative position of the probe 102 and the fiducial mark 108 in each measuring device 100, as an identification code provided on the identification plate 106, it is possible to obtain the type of the electronic component 130 which is measurable by the measuring device 100 and the relative position of the probe 102 and the fiducial mark 108 for each measuring device 100, from the imaging data of the identification plate 106.

In addition, in the above-described embodiment, the fiducial mark 108 is provided on the measuring device 100 which is attachable to and detachable from the mounting table 110. However, the fiducial mark 108 may be provided on the measuring device 100 fixed to the frame section 30, that is, the measuring device 100 which cannot be replaced. When positioning the electrode of the electronic component to the probe 102 of the measuring device 100, extremely accurate positioning is required. When the moving device 24 which moves the mounting head 28 moves for a long period of time, and there is a concern about thermal deformation, calibration of the moving device 24 is performed, a deformation amount is recognized, and a moving distance of the mounting head is adjusted. At this time, by using the fiducial mark 108 of the measuring device 100, it is possible to acquire an adjustment amount of the moving distance at high accuracy when the mounting head 28 positions the electrode of the electronic component to the probe 102.

### Reference Sign List

16: mounting machine, 28: mounting head, 78: conductive nozzle, 82: insulating nozzle, 90: mark camera (imaging device), 96: disposal box (disposal device), 100: measuring device, 102: probe (device side electrode), 106: identification plate (identification code), 108: fiducial mark, 110: mounting table (mounting section), 130: electronic component, 132: electrode (component side electrode), 140: component type identification section (identification device), 142: component type memory section, 144: relative position obtaining section (relative position obtaining device), 146: relative position memory section

## Claims

1. An electronic component mounting machine (16) which is configured to mount an electronic component (130) on a circuit board, comprising:
a measuring device (100) which includes a plurality of device side electrodes (102) that correspond to a plurality of component side electrodes (132) of the electronic component (130), and which is configured to measure electrical properties of the electronic component (130) as the plurality of device side electrodes (102) are electrically connected to the plurality of component side electrodes (132),
**characterized by**
a mounting table (110) on which the measuring device is mounted;
a convex section (112) which is formed on the upper surface of the mounting table (110); and
a concave section (114) having a shape which corresponds to the convex section (112) is formed on a lower surface of the measuring device (100),
wherein, as the concave section (114) is fitted to the convex section (112), the measuring device (100) is detachably mounted on the mounting table (110) in a single operation without using a tool.

2. The electronic component mounting machine according to claim 1, further comprising:
a magnet (116) fixed to the upper surface of the mounting table (110); and
a magnet (118) which is a magnet opposite to the magnet (116) is fixed to a lower surface of the measuring device (100), wherein
as the concave section (114) of the measuring device (100) is fitted to the convex section (112) of the mounting table (110), the magnets (116) and (118) face each other.

3. The electronic component mounting machine (16) according to claim 1 or 2,
wherein a fiducial mark for indicating a relative position of each of the plurality of device side electrodes is provided on the measuring device (100).

4. The electronic component mounting machine (16) according to any one of claims 1 to 3, further comprising:
a mounting head (28) including a suction nozzle (82) which is configured to hold the electronic component (130);
a camera (92) which is configured to take an image of the electronic component (130) held by the suction nozzle (82); and
a controller (122) which is configured to recognize a position of the plurality of component side electrodes (132) with respect to a center of the suction nozzle (82) by the image taken by the camera (92), and which is configured to move the mounting head (28) above the measuring device (100) based on the recognized position.

5. The electronic component mounting machine (16) according to any one of claims 1 to 4, further comprising:
a mounting head (28) including a suction nozzle (82) which is configured to hold the electronic component (130); and
a controller (122) which is configured to control the measuring device (100) to measure the electrical properties of the electronic component (130) as the plurality of device side electrodes (102) are electrically connected to the plurality of component side electrodes (132) of the electronic component (130) held by the suction nozzle (82).

6. The electronic component mounting machine (16) according to any one of claims 1 to 5, further comprising:
a mounting head (28) including an insulating suction nozzle (82) which is formed of an insulating material, and which is configured to hold the electronic component (130); and
a controller (122) which is configured to control the measuring device (100) to measure the electrical properties of the electronic component (130) as the plurality of device side electrodes (102) are electrically connected to the plurality of component side electrodes (132) of the electronic component (130) held by the insulating suction nozzle (82).

7. The electronic component mounting machine (16) according to any one of claims 1 to 6, further comprising:
a disposal device (96) which is configured to dispose the electronic component (130) of which the electrical properties are measured by the measuring device (100).

## Patentansprüche

1. Eine Maschine zur Montage von elektronischen Komponenten (16) die konfiguriert ist, eine elektronische Komponente (130) auf einer Leiterplatte zu montieren, umfassend:
eine Messvorrichtung (100), die eine Vielzahl von geräteseitigen Elektroden (102) umfasst, die einer Vielzahl von komponentenseitigen Elektroden (132) der elektronischen Komponente (130) entsprechen, und die konfiguriert ist elektrische Eigenschaften der elektronischen Komponente (130) zu messen, wenn die Vielzahl von geräteseitigen Elektroden (102) mit der Vielzahl von komponentenseitigen Elektroden (132) elektrisch verbunden sind,
**gekennzeichnet durch**
einen Montagetisch (110), auf dem die Messvorrichtung montiert ist;
einen konvexen Abschnitt (112), der an der oberen Fläche des Montagetisches (110) ausgebildet ist; und
einen konkaven Abschnitt (114) mit einer Form, die dem konvexen Abschnitt (112) entspricht, der an einer unteren Fläche der Messvorrichtung (100) ausgebildet ist,
wobei, da der konkave Abschnitt (114) an den konvexen Abschnitt (112) angepasst ist, die Messvorrichtung (100) in einem einzigen Arbeitsgang ohne Verwendung eines Werkzeugs abnehmbar auf dem Montagetisch (110) montiert wird.

2. Die Maschine zur Montage von elektronischen Komponenten (16) gemäß Anspruch 1, des Weiteren umfassend:
einen Magneten (116), der an der oberen Fläche des Montagetisches (110) befestigt ist; und
ein Magnet (118), der ein dem Magneten (116) gegenüberliegender Magnet ist, der an einer unteren Fläche der Messvorrichtung (100) befestigt ist, wobei
wenn der konkave Abschnitt (114) der Messvorrichtung (100) an dem konvexen Abschnitt (112) des Montagetisches (110) angebracht ist, die Magnete (116) und (118) einander gegenüberliegen.

3. Die Maschine zur Montage von elektronischen Komponenten (16) gemäß Anspruch 1 oder 2, wobei
auf der Messvorrichtung (100) eine Markierung zur Anzeige einer relativen Position jeder der mehreren geräteseitigen Elektroden angeordnet ist.

4. Die Maschine zur Montage von elektronischen Komponenten (16) gemäß einem der Ansprüche 1 bis 3, des Weiteren umfassend:
einen Montagekopf (28) mit einer Saugdüse (82), die konfiguriert ist die elektronische Komponente (130) zu halten;
eine Kamera (92), die konfiguriert ist ein Bild der von der Saugdüse (82) gehaltenen elektronischen Komponente (130) aufzunehmen; und
eine Steuerung (122), die konfiguriert ist eine Position der mehreren komponentenseitigen Elektroden (132) in Bezug auf eine Mitte der Saugdüse (82) durch das von der Kamera (92) aufgenommene Bild zu erkennen, und konfiguriert ist den Montagekopf (28) auf der Grundlage der erkannten Position über die Messvorrichtung (100) zu bewegen.

5. Die Maschine zur Montage von elektronischen Komponenten (16) gemäß einem der Ansprüche 1 bis 4, des Weiteren umfassend:
einen Montagekopf (28) mit einer Saugdüse (82) die konfiguriert ist die elektronische Komponente (130) zu halten; und
eine Steuereinrichtung (122), die konfiguriert ist die Messvorrichtung (100) so zu steuern, dass sie die elektrischen Eigenschaften der elektronischen Komponente (130) misst, wenn die mehreren geräteseitigen Elektroden (102) elektrisch mit den mehreren komponentenseitigen Elektroden (132) der von der Saugdüse (82) gehaltenen elektronischen Komponente (130) verbunden sind.

6. Die Maschine zur Montage von elektronischen Komponenten (16) gemäß einem der Ansprüche 1 bis 5, des Weiteren umfassend:
einen Montagekopf (28), der eine isolierende Saugdüse (82) enthält, die aus einem isolierenden Material gebildet ist und die konfiguriert ist die elektronische Komponente (130) zu halten; und
eine Steuereinrichtung (122), die konfiguriert ist die Messvorrichtung (100) so zu steuern, dass sie die elektrischen Eigenschaften der elektronischen Komponente (130) misst, wenn die mehreren geräteseitigen Elektroden (102) elektrisch mit den mehreren komponentenseitigen Elektroden (132) der von der isolierenden Saugdüse (82) gehaltenen elektronischen Komponente (130) verbunden sind.

7. Die Maschine zur Montage von elektronischen Komponenten (16) gemäß einem der Ansprüche 1 bis 6, des Weiteren umfassend:
eine Entsorgungseinrichtung (96), die dazu eingerichtet ist, die elektronische Komponente (130), dessen elektrische Eigenschaften von der Messeinrichtung (100) gemessen werden, zu entsorgen.

## Revendications

1. Machine de montage de composants électroniques (16) qui est configurée pour monter un composant électronique (130) sur une carte de circuits, comprenant :
un dispositif de mesure (100) qui inclut une pluralité d'électrodes latérales de dispositif (102) qui correspondent à une pluralité d'électrodes latérales de composant (132) du composant électronique (130), et qui est configuré pour mesurer des propriétés électriques du composant électronique (130) tandis que la pluralité d'électrodes latérales de dispositif (102) est connectée électriquement à la pluralité d'électrodes latérales de composant (132),
**caractérisée par**
un plateau de montage (110) sur lequel le dispositif de mesure est monté ;
une section convexe (112) qui est formée sur la surface supérieure du plateau de montage (110) ; et
une section concave (114) présentant une forme qui correspond à la section convexe (112) est formée sur une surface inférieure du dispositif de mesure (100),
dans laquelle, tandis que la section concave (114) est adaptée sur la section convexe (112), le dispositif de mesure (100) est monté de manière amovible sur le plateau de montage (110) en une seule opération sans utilisation d'un outil.

2. La machine de montage de composants électroniques selon la revendication 1, comprenant en outre :
un aimant (116) fixé sur la surface du plateau de montage (110) ; et
un aimant (118) qui consiste en un aimant opposé à l'aimant (116) est fixé sur une surface inférieure du dispositif de mesure (100), dans laquelle
tandis que la section concave (114) du dispositif de mesure (100) est adaptée sur la section convexe (112) du plateau de montage (110), les aimants (116) et (118) sont orientés l'un vers l'autre.

3. La machine de montage de composants électroniques (16) selon la revendication 1 ou 2,
dans laquelle une marque de repère pour indiquer une position relative de chacune de la pluralité d'électrodes latérales de dispositif est disposée sur le dispositif de mesure (100).

4. La machine de montage de composants électroniques (16) selon l'une quelconque des revendications 1 à 3, comprenant en outre :
une tête de montage (28) incluant une buse d'aspiration (82) qui est configurée pour tenir le composant électronique (130) ;
une caméra (92) qui est configurée pour prendre une image du composant électronique (130) tenu par la buse d'aspiration (82) ; et
un contrôleur (122) qui est configuré pour identifier une position de la pluralité d'électrodes latérales de composant (132) par rapport à un centre de la buse d'aspiration (82) par l'image prise par la caméra (92), et qui est configuré pour déplacer la tête de montage (28) au-dessus du dispositif de mesure (100) selon la position identifiée.

5. La machine de montage de composants électroniques (16) selon l'une quelconque des revendications 1 à 4, comprenant en outre :
une tête de montage (28) incluant une buse d'aspiration (82) est configurée pour tenir le composant électronique (130) ; et
un contrôleur (122) qui est configuré pour contrôler le dispositif (100) pour mesurer les propriétés électriques du composant électronique (130) tandis que la pluralité d'électrodes latérales de dispositif (102) est électriquement connectée à la pluralité d'électrodes latérales de composant (132) du composant électronique (130) tenu par la buse d'aspiration (82).

6. La machine de montage de composants électroniques (16) selon l'une quelconque des revendications 1 à 5, comprenant en outre :
une tête de montage (28) incluant une buse d'aspiration isolante (82) qui est constituée d'un matériau isolant, et qui est configurée pour tenir le composant électronique (130) ; et
un contrôleur (122) qui est configuré pour contrôler le dispositif de mesure (100) pour mesurer les propriétés électriques du composant électronique (130) tandis que la pluralité d'électrodes latérales de dispositif (102) est électriquement connectée à la pluralité d'électrodes latérales de composant (132) du composant électronique (130) tenu par la buse d'aspiration isolante (82).

7. La machine de montage de composants électroniques (16) selon l'une quelconque des revendications 1 à 6, comprenant en outre :
un dispositif d'élimination (96) qui est configuré pour éliminer le composant électronique (130) dont les propriétés électriques sont mesurées par le dispositif de mesure (100).
